# EUROPÄISCHE PATENTSCHRIFT

(11) **EP 1 071 214 B1**
(45) Veröffentlichungstag und Bekanntmachung des Hinweises auf die Patenterteilung: **31.08.2005**
(21) Anmeldenummer: 00115205.7
(22) Anmeldetag: 13.07.2000
(51) Int. Cl.: H03K 17/97, E05B 49/00, F16P 3/08

(54) **Überwachungseinrichtung**
Monitoring apparatus
Dispositif de surveillance

(30) Priorität: 22.07.1999 DE 19934370
(43) Veröffentlichungstag der Anmeldung: 24.01.2001
(73) Patentinhaber: K.A. SCHMERSAL GmbH & Co., D-42279 Wuppertal (DE)
(72) Erfinder: Letzel, Helmut, 51069 Köln (DE); Franke, Uwe, 42281 Wuppertal (DE)
(74) Vertreter: Sparing Röhl Henseler Patentanwälte European Patent Attorneys

(56) Entgegenhaltungen:
- EP-A- 0 825 628
- WO-A-85/03970
- DE-A- 19 711 588
- US-A- 3 810 145

## Beschreibung

Die Erfindung betrifft eine Überwachungseinrichtung nach dem Oberbegriff des Anspruchs 1.

Eine derartige Überwachungseinrichtung ist aus DE-A-197 11 588 bekannt, bei der ein üblicher Sicherheitsschalter vorgesehen ist, der von einem schlüsselartigen Betätiger betätigbar ist, der seinerseits an einer Tür od.dgl. befestigt ist. Die Tür selbst ist über einen separaten Handgriff zu öffnen bzw. zu schließen. Der Betätiger wird hierbei einfach an der Tür angeschraubt und ist daher auch ohne großen Aufwand abnehmbar. Dies führt jedoch dazu, daß der Sicherheitsschalter durch den abmontierten Betätiger bei geöffneter Tür betätigt und damit der Sicherheitsschalter überlistet werden kann.

Außerdem ist aus EP-A-0 825 628 eine Überwachungseinrichtung bekannt, bei der wenigstens ein Sicherheitsschalter vorgesehen ist, der über einen schlüsselartigen Betätiger betätigbar ist. Der Betätiger ist hierbei mittels eines Türgriffs und eines Zahnkranzsegmentes, das mit einem Zahnstangenabschnitt des Betätigers in Eingriff steht, im geschlossenen Zustand der Tür in das Gehäuse des Sicherheitsschalters längsverschieblich, um letzteren mechanisch zu betätigen.

Aufgabe der Erfindung ist es, eine Überwachungseinrichtung nach dem Oberbegriff des Anspruchs 1 zu schaffen, deren Sicherheitsschalter neben der Ermöglichung seiner berührungslosen Auslösung und mechanischen Verriegelung eine Betätigung praktisch nur bei geschlossenem beweglichem Element ermöglicht.

Diese Aufgabe wird entsprechend dem kennzeichnenden Teil des Anspruchs 1 gelöst.

Weitere Ausgestaltungen der Erfindung sind der nachfolgenden Beschreibung und den Unteransprüchen zu entnehmen.

Die Erfindung wird nachstehend anhand von in den beigefügten Abbildungen schematisiert dargestellten Ausführungsbeispielen näher erläutert.
Fig. 1 und 2 zeigen eine Ausführungsform eines Sicherheitsschalters im Schnitt um zwei um 90° versetzte Ebenen.
Fig. 3, 4 bzw. 5, 6 zeigen den Sicherheitsschalter von Fig. 1, 2 in zwei Einbauzuständen bei geöffneter bzw. geschlossener Tür.
Fig. 7 bis 8 zeigen eine zusätzliche Ausführungsform eines Sicherheitsschalters in zwei unterschiedlichen Positionen in bezug auf eine Verriegelung im Schnitt.
Fig. 9 zeigt ausschnittweise eine Ausführungsform einer Entriegelungseinrichtung für einen Sicherheitsschalter.

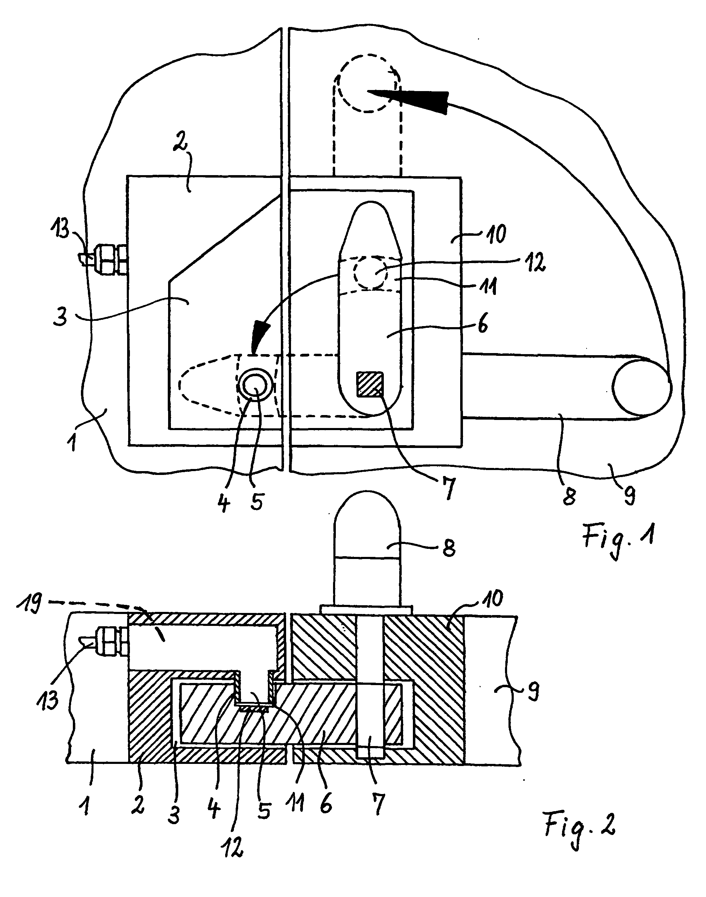

Der in Fig. 1, 2 dargestellte Sicherheitsschalter umfaßt ein an einer feststehenden Schutzeinrichtung 1 befestigten Gehäuse 2, das einen Aufnahmeraum 3 aufweist, in dem ein Verriegelungszapfen 4 angeordnet ist, der einen Lesekopf 5 trägt. Der Sicherheitsschalter umfaßt ferner einen Betätiger 6, der über einen Zapfen 7 mit einem Handgriff 8 eines beweglichen Elements 9 etwa in Form einer Tür (Schiebe- oder Schwenktür, in letzterem Fall vorhandene Scharniere nicht dargestellt) gekoppelt ist. Der Betätiger 6 wird in seiner nicht verriegelnden Position (Fig. 1) von einem am Element 9 befestigten Gehäuseteil 10 aufgenommen und ist mittels des Handgriffs 8 um einen Winkel von etwa 90° verschwenkbar (in Fig. 1 gestrichelt bzw. durchgezogen dargestellt). Der Betätiger 6 besitzt eine um die Achse des Zapfens 7 gekrümmte Nut 11 zur Aufnahme des Verriegelungszapfens 4 in der verriegelnden Endposition des Betätigers 6 (in Fig. 1 gestrichelt).

In der dargestellten Ausführungsform trägt der Betätiger 6 einen spezifisch kodierten Auslöser 12 (Transponder), der am Boden der Nut 11 angeordnet ist, so daß sich in der verriegelnden Endposition des Betätigers 6 der Auslöser 12 gegenüber von dem Lesekopf 5 des Verriegelungszapfens 4 befindet, so daß letzterer induktiv die Spannungsversorgung des Auslösers 12 vornehmen und die Daten des Auslösers 12 lesen kann.

Lesekopf 5 und Auslöser 12 können aber auch an anderen Stellen in der geschlossenen Stellung des Betätigers 6 einander gegenüberliegend angeordnet sein, so etwa der Auslöser 12 in der Spitze des Betätigers 6 und der Lesekopf 5 benachbart zum Aufnahmeraum 3 in korrespondierender Stellung.

Der Lesekopf 5 ist bei der in Fig. 1, 2 dargestellten Ausführungsform über ein Kabel 13 mit einer hier nicht dargestellten Auswerteeinrichtung verbunden, die aber auch in das Gehäuse 2 integriert sein kann.

Wie bereits in Fig. 9 von EP-A-0 825 628 dargestellt, umschließt die feststehende Schutzeinrichtung 1 einen beispielsweise begehbaren, verschließbaren Raumbereich mit einer maschinellen Anlage, etwa einer Roboterfertigungsanlage. Der Raumbereich ist über mindestens eine Tür od.dgl. als beweglichem Element 9 zugänglich, wobei die Position der Tür über den Sicherheitsschalter überwacht wird. Letzterer ist mit einer Steuerung gekoppelt, die auch mit der maschinellen Anlage gekoppelt ist, um den Sicherheitsschalter entsprechend dem Betriebszustand der maschinellen Anlage freizugeben bzw. zu sperren. Wenn der Steuerung ein Stillstehen der beweglichen Teile der maschinellen Anlage signalisiert wird, gibt sie den Sicherheitsschalter frei, so daß der von der Schutzeinrichtung 1 umschlossene Raumbereich durch Öffnen der wenigstens einen Tür zugänglich wird. Stehen zumindest Teil der maschinellen Anlage, die eine Gefährdung des Personals hervorrufen könnten, nicht still, wird der Sicherheitsschalter blockiert, so daß die Türen nicht von außen geöffneten werden können. Außerdem verhindert die Steuerung bei wenigstens einer geöffneten Tür ein Inbetriebnehmen der maschinellen Anlage.

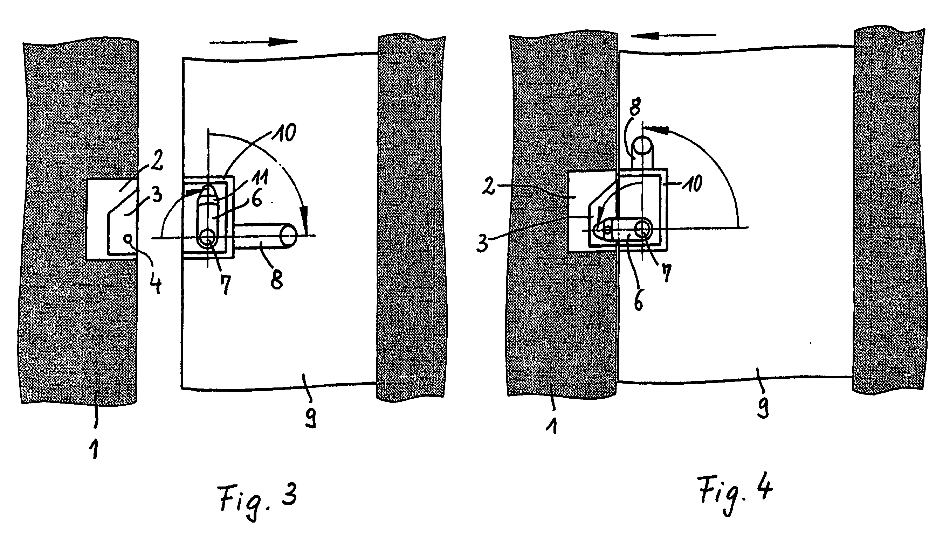

Der in den Fig. 1, 2 dargestellte Sicherheitsschalter ist in den Fig. 3, 4 bei geöffneten bzw. verschlossenem und verriegeltem Element 9 in Form einer Schwenk- oder Schiebetür dargestellt.

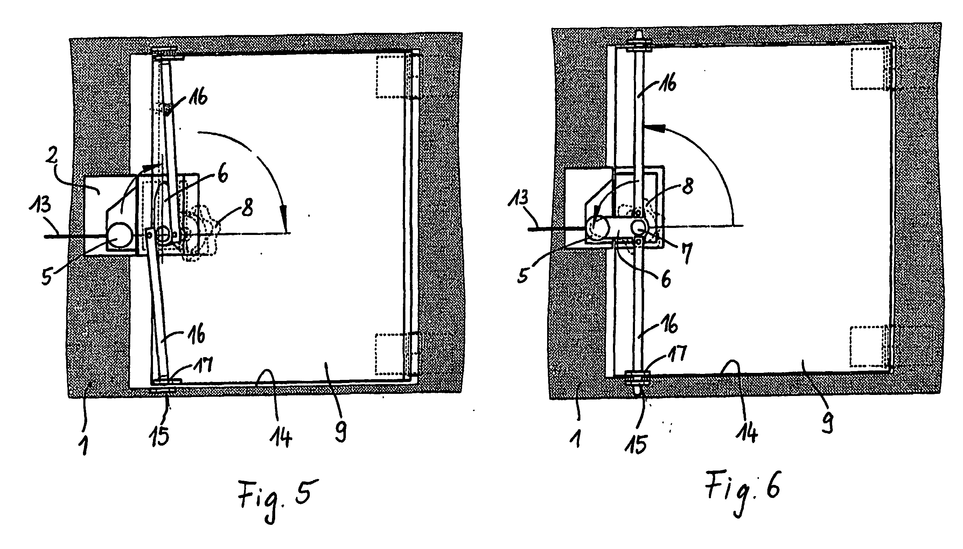

In den Fig. 5, 6 ist die Schutzeinrichtung 1 ober- und unterseitig zu einer Öffnung 14, die durch das in Form einer angelenkten Klappe oder Tür ausgebildete Element 9 verschließbar ist, an der der Anlenkseite gegenüberliegenden Seite jeweils mit einer Aufnahmeöffnung 15 für jeweils eine Verriegelungsstange 16 versehen, wobei die Verriegelungsstangen 16 benachbart zum Betätiger 6 angelenkt und über Führungsaugen 17 in der geschlossenen Stellung des Elements 9 benachbart zu den Aufnahmeöffnungen 15 geführt, so daß sie bei Betätigung des als Drehknopf ausgebildeten Handgriffs 8 in der geschlossenen Stellung des Elements 9 mit den Aufnahmeöffnungen 15 zum Verriegeln des Elements 9 gegenüber der Schutzeinrichtung in Eingriff gelangen. - Hierbei benötigt der Sicherheitsschalter nicht zwingend den Verriegelungszapfen 4 und der Betätiger 6 nicht die Nut 11. Der Lesekopf 5 kann in einer Wandung benachbart zum Aufnahmeraum 3 und der Auslöser 12 im vorderen Ende des Betätigers 6 angeordnet sein.

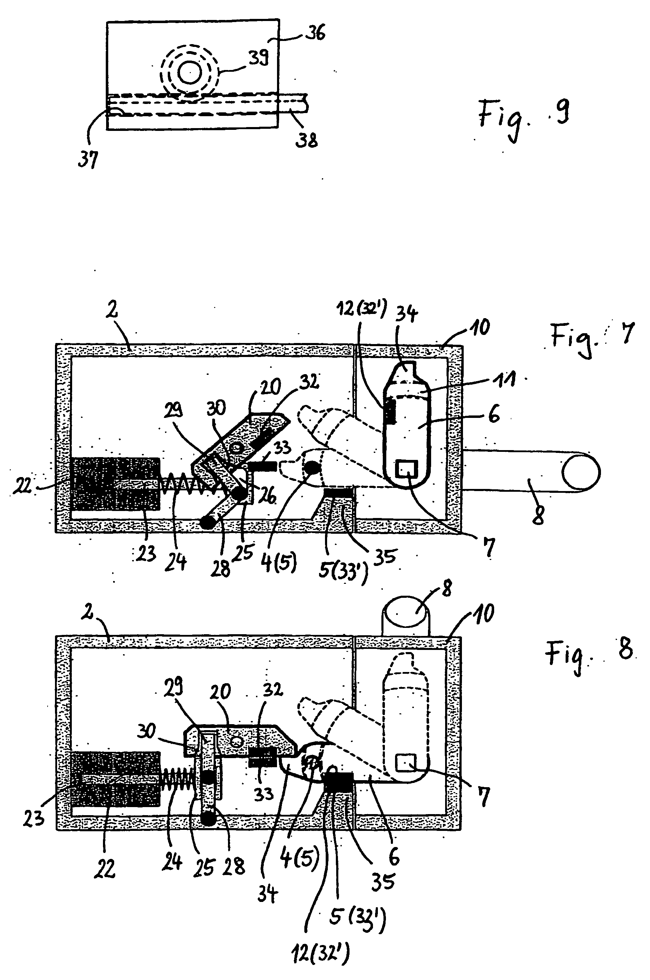

Bei der in den Fig. 7 bis 8 dargestellten Ausführungsform ist der Betätiger 6 mittels des Handgriffs 8 um einen Winkel von etwa 90° verschwenkbar, mit einer Nut 11 wie bei der Ausführungsform der Fig. 1, 2 und an seinem freien Ende mit einer Nase 34 versehen. Im Gehäuse 2 ist der mit der Nut 11 zusammenwirkende Verriegelungszapfen 4 und ein gegebenenfalls als Anschlag für den Betätiger 6 dienender Vorsprung 35 vorgesehen, wobei der Vorsprung 35 den Lesekopf 5 und der Betätiger 6 den Auslöser 12 trägt.

Auch hier ist wiederum entsprechend wie bei der Ausführungsform der Fig. 7, 8 der durch den Elektromagneten 22 betätigbare Riegel 20 vorgesehen, der mit der Nase 34 des Betätigers 6 zusammenwirkt, um den Riegel 20 im Gehäuse 2 zu verriegeln. Der Riegel 20 ist hierbei etwa mittig im Gehäuse 2 angelenkt und benötigt keine separate Rückstellfeder. Hierbei wird wiederum die verriegelnde Position des Riegels 20 durch das Auslöseelement 32 und das im Gehäuse 2 angebrachte Gegenelement 33 überwacht.

Bei dieser Ausführungsform kann auch, wie bei Fig. 1, 2, der Lesekopf 5 am Verriegelungszapfen 4 und der Auslöser 12 am Boden der Nut 11 angeordnet sein, während der Vorsprung 35 und der Betätiger 6 zusätzlich ein Auslöseelement 32' und ein Gegenelement 33' tragen, etwa der Betätiger 6 einen Permanentmagneten und der Vorsprung 35 einen Reedkontakt oder Hallsensor, um eine zweikanalige Überwachung sicherzustellen.

Letztere kann aber auch dadurch bewirkt werden, daß in den jeweiligen Ausführungsformen einerseits ein Auslöser 12 (Transponder) zusammen mit einem nach einem anderen physikalischen Prinzip als der Auslöser 12 arbeitenden Auslöseelement 32' (Permanentmagnet) und andererseits ein Lesekopf 5 für den Auslöser 12 und ein durch das Auslöseelement 32' auslösbares Gegenelement 33' (Reedkontakt, Hallsensor), die insbesondere Baueinheiten bilden, verwendet wird.

Anstelle eines Elektromagneten 22 läßt sich auch ein Elektromotor 36 (Schrittmotor), vgl. Fig. 9, verwenden, dessen Gehäuse eine Führung 37 für eine Zahnstange 38 aufweist, die anstelle des Ankers 23 mit dem Aufnahmestück 25, vgl. Fig. 7, 8, verbunden ist und mit einem vom Elektromotor 36 antreibbaren Ritzel 39 in dessen Gehäuse in Eingriff steht. Hierbei ist insbesondere ein Elektromotor 36 zweckmäßig, der automatisch in seine Ausgangsstellung zurückfährt. Trotz geringerer Wärmeentwicklung des Elektromotors 36 läßt sich hiermit eine größere Haltekraft im Vergleich zu einem Elektromagneten 22 erzielen.

## Patentansprüche

1. Überwachungseinrichtung für einen geschützten Raumbereich einer maschinellen Anlage, wobei der Raumbereich über wenigstens eine Zugangsöffnung zugänglich ist, die über ein zwischen einer geöffneten und einer geschlossenen Stellung bewegliches Element (9) in Form einer Tür, Klappe od.dgl. verschließbar ist, wobei ein ein Gehäuse (2) aufweisender, an eine Auswerteeinrichtung (19) angeschlossener Sicherheitsschalter benachbart zu dem beweglichen Element (9) angeordnet ist, dessen Lesekopf (5) in einem am beweglichen Element (9) befindlichen kodierten Auslöser (12) gespeicherte Daten in der geschlossenen Stellung des beweglichen Elements (9) liest, und das bewegliche Element (9) einen in seiner Endposition im Gehäuse (2) das bewegliche Element (9) in seiner geschlossenen Position verriegelnden Betätiger (6) aufweist, der den Auslöser (12) trägt, während das Gehäuse (2) einen Aufnahmeraum (3) für den Betätiger (6) besitzt und den Lesekopf (5) in einer Position aufnimmt, in der er sich in der Endposition des Betätigers (6) im Gehäuse (2) benachbart zum Auslöser (12) befindet, **dadurch gekennzeichnet, daß** der Betätiger (6) gegenüber dem beweglichen Element (9) durch Kopplung mit einem am beweglichen Element (9) vorgesehenen Handgriff (8) verschwenkbar ist und eine sich in seiner Schwenkrichtung erstreckende Nut (11) für einen Aufnahmeraum (3) des Gehäuses (2) angeordneten Verriegelungszapfen aufweist.

2. Überwachungseinrichtung nach Anspruch 1, **dadurch gekennzeichnet, daß** der Auslöser (2) am Boden der Nut (11) und der Lesekopf (5) am Verriegelungszapfen (4) angeordnet ist.

3. Überwachungseinrichtung nach Anspruch 1 oder 2, **dadurch gekennzeichnet, daß** der Betätiger (6) über den Handgriff (8) um einen vorbestimmten Winkel, vorzugsweise um etwa 90°, verschwenkbar ist.

4. Überwachungseinrichtung nach einem der Ansprüche 1 bis 3, **dadurch gekennzeichnet, daß** in dem Gehäuse (2) ein mit dem Betätiger (6) in Eingriff bringbarer Riegel (20) vorgesehen ist.

5. Überwachungseinrichtung nach Anspruch 4, **dadurch gekennzeichnet, daß** der Riegel (20) mittels eines elektrisch eine Hubbewegung bewirkenden Elements, insbesondere eines Elektromagneten (22) oder eines Elektromotors (36), entriegelbar ist.

6. Überwachungseinrichtung nach Anspruch 4 oder 5, **dadurch gekennzeichnet, daß** der Riegel (20) im Gehäuse (2) verschwenkbar oder verschiebbar angeordnet ist.

7. Überwachungseinrichtung nach einem der Ansprüche 4 bis 6, **dadurch gekennzeichnet, daß** der Riegel (20) in dessen verriegelnder Position vom Betätiger (6) überfahrbar ist.

8. Überwachungseinrichtung nach einem der Ansprüche 5 bis 7, **dadurch gekennzeichnet, daß** das elektrisch eine Hubbewegung bewirkende Element in der verriegelnden Position des Riegels (20) stromlos ist.

9. Überwachungseinrichtung nach Anspruch 8, **dadurch gekennzeichnet, daß** das elektrisch eine Hubbewegung bewirkende Element durch Erreichen der Leseposition des Auslösers (12) bezüglich des Lesekopfes (5) stromlos schaltbar ist.

10. Überwachungseinrichtung nach einem der Ansprüche 4 bis 9, **dadurch gekennzeichnet, daß** der Riegel (20) ein dessen verriegelnde Position anzeigendes, mit einem Gegenelement (33) im Gehäuse (2) zusammenwirkendes Auslöseelement (32) aufweist.

11. Überwachungseinrichtung nach einem der Ansprüche 1 bis 10, **dadurch gekennzeichnet, daß** der Betätiger (6) ein dessen Endposition im Gehäuse (2) zusätzlich anzeigendes, mit einem Gegenelement (33') im Gehäuse (2) zusammenwirkendes Auslöseelement (32') aufweist.

12. Überwachungseinrichtung nach Anspruch 9 oder 10, **dadurch gekennzeichnet, daß** das Auslöseelement (32, 32') ein Permanentmagnet ist, der mit einem hierauf ansprechenden Sensor, insbesondere einem Reedkontakt oder Hallsensor, als Gegenelement (33, 33') im Gehäuse (2) zusammenwirkt.

13. Überwachungseinrichtung nach Anspruch 11 oder 12, **dadurch gekennzeichnet, daß** der Auslöser (12) und das Auslöseelement (32') ebenso wie der Lesekopf (5) und das Gegenelement (33') jeweils zu einer Baueinheit zusammengefaßt sind.

## Claims

1. Monitoring device for a protected zone of a machine-based equipment, the zone being accessible by means of at least one access opening which is arranged to be closed by means of an element (9) in the form of a door, flap or the like that is movable between an opened position and a closed position, there being arranged adjacent to the movable element (9) a safety switch having a housing (2) and being connected to an evaluating device (19), the reading head (5) of which reads, in the closed position of the movable element (9), data stored in a coded trigger device (12) located on the movable element (9), and the movable element (9) having an actuator (6) which in its end position in the housing (2) locks the movable element (9) in its closed position, which actuator (6) carries the trigger device (12), while the housing (2) has a receiving chamber (3) for the actuator (6) and accommodates the reading head (5) in a position in which it is located adjacent to the trigger device (12) when the actuator (6) is in its end position in the housing (2), **characterised in that** the actuator (6) is pivotable relative to the movable element (9) as a result of its being coupled to a handle (8) provided on the movable element (9) and has, extending in its pivot direction, a groove (11) for a locking pin arranged in the receiving chamber (3) of the housing (2).

2. Monitoring device according to claim 1, **characterised in that** the trigger device (12) is arranged at the base of the groove (11) and the reading head (5) is arranged on the locking pin (4).

3. Monitoring device according to claim 1 or 2, **characterised in that** the actuator (6) is pivotable through a predetermined angle, preferably through about 90°, by means of the handle (8).

4. Monitoring device according to any one of claims 1 to 3, **characterised in that** there is provided in the housing (2) a locking bar (20) which can be brought into engagement with the actuator (6).

5. Monitoring device according to claim 4, **characterised in that** the locking bar (20) can be released by means of an element that electrically effects a stroke movement, especially an electromagnet (22) or an electric motor (36).

6. Monitoring device according to claim 4 or 5, **characterised in that** the locking bar (20) is arranged to pivot or slide in the housing (2).

7. Monitoring device according to any one of claims 4 to 6, **characterised in that** the locking bar (20) is movable into its locking position by the actuator (6).

8. Monitoring device according to any one of claims 5 to 7, **characterised in that** the element that electrically effects a stroke movement is without current when the locking bar (20) is in the locking position.

9. Monitoring device according to claim 8, **characterised in that** the element that electrically effects a stroke movement is switchable to a no-current condition as a result of the trigger device (12) reaching its reading position relative to the reading head (5).

10. Monitoring device according to any one of claims 4 to 9, **characterised in that** the locking bar (20) has a triggering element (32) that indicates the locking position of the locking bar and cooperates with a counter-element (33) in the housing (2).

11. Monitoring device according to any one of claims 1 to 10, **characterised in that** the actuator (6) has a triggering element (32') that additionally indicates the end position of the actuator in the housing (2) and cooperates with a counter-element (33') in the housing (2).

12. Monitoring device according to claim 9 or 10, **characterised in that** the triggering element (32, 32') is a permanent magnet which cooperates with a sensor responsive thereto, especially a Reed contact or Hall sensor, as counter-element (33, 33') in the housing (2).

13. Monitoring device according to claim 11 or 12, **characterised in that** the trigger device (12) and the triggering element (32') as well as the reading head (5) and the counter-element (33') are in each case combined to form a unit.

## Revendications

1. Dispositif de surveillance pour une zone protégée d'une installation regroupant des machines, dans lequel la zone est accessible au moins par une ouverture d'accès qui peut être fermée par l'intermédiaire d'un élément mobile (9) entre une position ouverte et une position fermée, se présentant sous la forme d'une porte, d'une trappe ou similaire, moyennant quoi un commutateur de sécurité, présentant un boîtier (2), connecté à un dispositif d'évaluation (19), est disposé de manière adjacente à l'élément mobile (9), dont la tête de lecture (5) lit les données enregistrées dans un déclencheur codé (12) apposé sur l'élément mobile (9), dans la position fermée de l'élément mobile (9), et l'élément mobile (9) présente un actionneur (6) qui, dans sa position finale dans le boîtier (2), bloque l'élément mobile (9) dans sa position fermée, lequel supporte le déclencheur (12), tandis que le boîtier (2) comporte un espace de logement (3) pour l'actionneur (6) et loge la tête de lecture (5) dans une position dans laquelle il se trouve, dans la position finale de l'actionneur (6) dans le boîtier (2), en étant adjacent au déclencheur (12),
**caractérisé en ce que** l'actionneur (6) peut être amené à pivoter par rapport à l'élément mobile (9) par l'intermédiaire d'un accouplement avec une poignée (8) prévue sur l'élément mobile (9), et possède une rainure (11) s'étendant dans sa direction de pivotement, qui reçoit le boulon de verrouillage disposé dans l'espace de logement (3) du boîtier (2).

2. Dispositif de surveillance selon la revendication 1, **caractérisé en ce que** le déclencheur (12) est disposé au fond de la rainure (11), et la tête de lecture (5) est disposée sur le boulon de verrouillage (4).

3. Dispositif de surveillance selon la revendication 1 ou 2, **caractérisé en ce que** l'actionneur (6) est pivotable par l'intermédiaire de la poignée (8) sur un angle prédéterminé, de préférence d'environ 90°.

4. Dispositif de surveillance selon l'une quelconque des revendications 1 à 3, **caractérisé en ce que**, dans le boîtier (2), il est également prévu un verrou (20), pouvant venir en prise avec l'actionneur (6).

5. Dispositif de surveillance selon la revendication 4, **caractérisé en ce que** le verrou (20) peut être débloqué à l'aide d'un élément provoquant un mouvement de levage par voie électrique, en particulier un électroaimant (22) ou un moteur électrique (36).

6. Dispositif de surveillance selon la revendication 4 ou 5, **caractérisé en ce que** le verrou (20) peut être amené à pivoter ou à se déplacer dans le boîtier (2).

7. Dispositif de surveillance selon l'une quelconque des revendications 4 à 6, **caractérisé en ce que** le verrou (20) peut être dépassé par l'actionneur (6) dans sa position de verrouillage.

8. Dispositif de surveillance selon l'une quelconque des revendications 5 à 7, **caractérisé en ce que** l'élément provoquant un mouvement de levage par voie électrique est sans courant dans la position de verrouillage du verrou (20).

9. Dispositif de surveillance selon la revendication 8, **caractérisé en ce que** l'élément provoquant un mouvement de levage par voie électrique peut être embrayé sans courant, en atteignant la position de lecture du déclencheur (12) par rapport à la tête de lecture (5).

10. Dispositif de surveillance selon l'une quelconque des revendications 4 à 9, **caractérisé en ce que** le verrou (20) présente un élément de déclenchement (32), affichant sa position de verrouillage, agissant conjointement avec un contre-élément (33) dans le boîtier (2).

11. Dispositif de surveillance selon l'une quelconque des revendications 1 à 10, **caractérisé en ce que** l'actionneur (6) présente un élément de déclenchement (32') affichant en outre sa position finale dans le boîtier (2), et agissant conjointement avec un contre-élément (33') dans le boîtier (2).

12. Dispositif de surveillance selon la revendication 9 ou 10, **caractérisé en ce que** l'élément de déclenchement (32, 32') est un aimant permanent, qui agit conjointement avec un détecteur sensible à celui-ci, en particulier un contact à lames souples ou détecteur à effet Hall, faisant office de contre-élément (33, 33') dans le boîtier (2).

13. Dispositif de surveillance selon la revendication 11 ou 12, **caractérisé en ce que** le déclencheur (12) et l'élément de déclenchement (32'), ainsi que la tête de lecture (5) et le contre-élément (33') sont respectivement regroupés sous la forme d'un composant.
